# EUROPEAN PATENT SPECIFICATION

(11) **EP 0 954 205 B1**
(45) Date of publication and mention of the grant of the patent: **11.05.2005**
(21) Application number: 99105697.9
(22) Date of filing: 19.03.1999
(51) Int. Cl.: H05B 33/14

(54) **Organic electroluminescent device and method for producing it**
Organisches Elektrolumineszenzelement und Verfahren zu dessen Herstellung
Dispositif électroluminescent organique et procédé pour la production du même

(30) Priority: 24.03.1998 JP 7534898
(43) Date of publication of application: 03.11.1999
(73) Proprietor: SONY CORPORATION, Tokyo (JP)
(72) Inventor: Tamura, Shinichiro, Shinagawa-ku, Tokyo (JP); Ishibashi, Tadashi, Shinagawa-ku, Tokyo (JP)
(74) Representative: Müller - Hoffmann & Partner

(56) References cited:
- DE-A- 4 343 412
- US-A- 5 294 870
- DATABASE WPI Section Ch, Week 199203 Derwent Publications Ltd., London, GB; Class L03, AN 1992-020645 XP002901562 & JP 03 269995 A (RICOH KK), 2 December 1991 (1991-12-02)

## Description

### BACKGROUND OF THE INVENTION

### Field of the Invention:

The present invention relates to an organic electroluminescent device (organic EL device), in particular, to an organic EL device having an organic layer, which has a light-emitting region and is formed between an anode and a cathode, and containing a substance capable of emitting light through current injection thereinto as a constituent element, and also to a method for producing it.

### Description of the Related Art:

Light-weight and high-efficiency flat panel displays are being much studied and developed, for example, for picture display in computers and televisions.

First, as having high luminance and good color reproducibility, cathode-ray tubes (CRT) are most used at present in displays, but are problematic in that they are bulky and heavy and consume much power.

On the other hand, as light-weight and high-efficiency flat panel displays, active matrix drive-type liquid-crystal displays have been commercialized in the market. However, liquid-crystal displays are problematic in that the viewing angle is narrow, that the power to be consumed by the backlight is large in dark environments since they are not self-luminescent, and that they do not have satisfactory responsibility to high-resolution high-speed video signals. In particular, other problems are that large picture-size liquid-crystal displays are difficult to produce and the production costs for them are high.

Light-emitting diode displays could be substituents for them, which, however, are still problematic in that the production costs for such displays are high and that it is difficult to form a light-emitting diode matrix structure on one substrate. In that situation, there are many serious problems to be solved before low-priced display candidates substitutable for cathode-ray tubes could be put into practical use.

As flat panel displays capable of solving the problems noted above, organic electroluminescent devices (organic EL devices) comprising an organic light-emitting material have become widely noted in the art. Specifically, it is expected to realize flat panel displays with no viewing angle dependency, which comprise an organic layer of a light-emitting material and which are self-luminescent and are characterized by high speed of response.

Regarding its constitution, an organic electroluminescent device comprises a light-transmitting positive electrode and a metal negative electrode, and a thin organic film containing a light-emitting material as sandwiched between the two electrodes. The organic material to form such an electroluminescent device is grouped into a high-molecular material to be prepared by polymerization of monomers and a low-molecular material. In general, the high-molecular material could not be formed into films through vacuum vapor deposition. Therefore, coating of its solution or jetting thereof in an ink-jetting system is employed in using it in producing devices. As opposed to this, laminate structures to be formed through vacuum vapor deposition has been essentially studied for the low-molecular material.

Furthermore, JP 03 26995 describes an electroluminescent device having three layers sandwiched between the anode and the cathode.

Further, C.W. Tang, S.A. VanSlyke, et al. have developed, as in their study report disclosed in Applied Physics Letters, Vol. 51, No. 12, pp. 913 to 915 (1987), a device structure (single hetero-structured organic EL device) in which the thin organic film has a two-layered structure composed of a thin film of a hole-transporting material and a thin film of an electron-transporting material and in which the holes and the electrons having been injected into the organic film from each electrode are re-combined to emit light.

In that device structure, any of the hole-transporting material or the electron-transporting material further acts as a light-emitting material, and the light emission occurs in the waveband that corresponds to the energy gap between the ground state and the excited state of the light-emitting material. The two-layered structure in that device has realized great reduction in the driving voltage and increase in the light-emitting efficiency.

After that, a three-layered structure (double hetero-structured organic EL device) of a hole-transporting material, a light-emitting material and an electron-transporting material has been developed by C. Adachi, S. Tokita, T. Tsutsui, S. Saito, et al., as in their study report disclosed in Japanese Journal of Applied Physics, Vol. 27, No. 2, pp. L269 to L271 (1988); and a device structure comprising a light-emitting material as incorporated in an electron-transporting material has been developed by C.W. Tang, S.A. VanSlyke, C.H. Chen, et al., as in their study report disclosed in Journal of Applied Physics, Vol. 65, No. 9, pp. 3610 to 3616 (1989). In their studies, the possibility of low-voltage and high-luminance light emission has been discussed and verified, and their studies have led many recent studies and developments in the art.

However, vacuum vapor deposition apparatus to be used in forming the thin organic films noted above are generally expensive, and continuous production of such thin organic films is difficult. Therefore, the integrated production of devices in vacuum is problematic in that the production costs shall be high. On the other hand, for example, when an electron-transporting material is incorporated into a light-emitting material, a plurality of vapor sources are prepared and are separately vaporized at different vaporization rates. In this process, however, it is not easy to stably control the vapor concentrations.

In addition, since the above-mentioned structure is a laminate structure comprising a hole-transporting layer and an electron-transporting layer, it requires complicated operation for forming it and the conditions for forming it are difficult to settle.

### SUMMARY OF THE INVENTION

The object of the present invention is to provide an advanced, organic electroluminescent device, and an inexpensive, high-producibility method for producing it.

We, the present inventors have assiduously studied in order to solve the problems noted above. As a result, having broken the commonly accepted theory, we have found that even a thin film as formed through solution coating of a low-molecular material brings about electroluminescence, and have achieved the present invention.

Specifically, the invention relates to an organic electroluminescent device having a coated or printed layer of at least one organic light-emitting material not having any polymeric repetition in the chemical structure. (This is hereinafter referred to as the organic EL device of the invention.)

The light-emitting material is formed as a single material between the anode and the cathode.

The invention also provides a method for producing an organic electroluminescent device, which comprises a step of coating or printing a material that contains at least one organic light-emitting material not having any polymeric repetition in the chemical structure, thereby forming a coated or printed layer of the organic light-emitting material. (This is hereinafter referred to as the production method of the invention.)

In the organic EL device and the production method of the invention, an organic light-emitting material not having any polymeric repetition in the chemical structure (that is, a low-molecular one) is coated or printed. Therefore, the invention where a solution of such a low-molecular, organic light-emitting material is coated or printed to produce the device is superior to using high-molecular materials in that the wavelength of the light to be emitted by the device and also the thermal characteristics and others of the device are easily controlled through molecular designing of the low-molecular material to be used, that the synthetic reaction for producing the low-molecular material is controlled with accuracy as not including polymerization, and that the synthesized low-molecular material can be purified more easily than high-molecular materials. According to the invention, therefore, there are provided high-performance devices at low costs, and the producibility for the devices is high.

In addition, the organic light-emitting material forms a single coated or printed layer as a light-emitting layer in the device of the invention. Therefore, the invention does not require the formation of conventional laminate structures, and the operation for forming the layer is easy. The layer can be formed in a simplified manner merely by settling the coating or printing condition for it.

One or more of the above-mentioned organic light-emitting materials can be used either singly or as combined.

### BRIEF DESCRIPTION OF THE DRAWINGS

Fig. 1 is a cross-sectional view graphically showing the essential part of the organic electroluminescent device of the invention;
Fig. 2 is a constitutional view showing a full-color-type flat display in which is used the organic electroluminescent device of the invention;
Fig. 3 is the luminance-voltage characteristic profile of one example of the organic electroluminescent device of the invention;
Fig. 4 is the current density-voltage characteristic profile of the device;
Fig. 5 is a pattern of the emission spectrum of the device;
Fig. 6 is the luminance-voltage characteristic profile of another example of the organic electroluminescent device of the invention;
Fig. 7 is the current density-voltage characteristic profile of the device;
Fig. 8 is the CIE chromaticity diagram of the luminescent color of the device;
Fig. 9 is the luminance-voltage characteristic profile of still another example of the organic electroluminescent device of the invention;
Fig. 10 is the current density-voltage characteristic profile of the device; and
Fig. 11 is the CIE chromaticity diagram of the luminescent color of the device.
Fig. 12 is a graphic view showing a micro-gravure coater to be used in forming still another example of the organic electroluminescent device of the invention.

### DESCRIPTION OF PREFERRED EMBODIMENTS OF THE INVENTION

Preferably, in the organic EL device and the production method for it of the invention, the organic light-emitting material is in the light-emitting layer having been formed through coating or printing, and the light-emitting layer that contains at least either a hole-transporting material or an electron-transporting material, and the organic light emitting material is formed through coating or printing (that is, the light-emitting layer is formed as a single layer through coating or printing).

Where the driving electrode for the light-emitting layer is formed through coating or printing of an organic material containing a conductive powder, it is unnecessary to form the electrode through vapor deposition. In this embodiment, the formation of the device is more easy.

The coating may be effected by any of spin coating, dipping or spray coating. The printing may be effected by any of relief printing, lithographic printing, gravure printing, flexographic printing or screen printing.

One example of the organic electroluminescent device of the invention is described with reference to the drawings attached hereto.

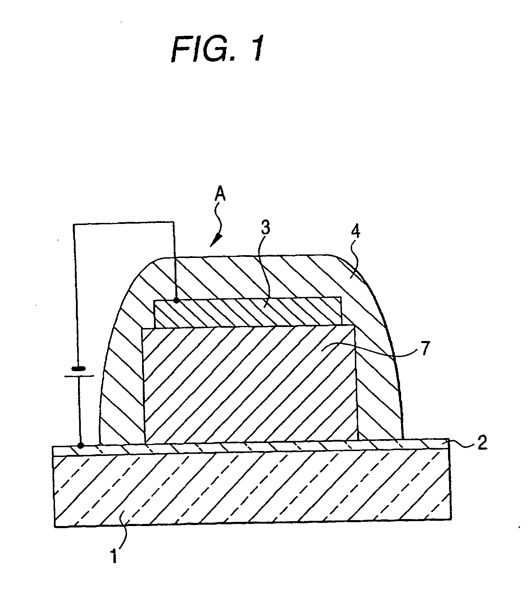

Fig. 1 shows an organic electroluminescent device A, which has a laminate structure as constructed by laminating a light-transmitting anode (transparent anode) 2, a light-emitting layer 7 of a thin, organic coated film that contains the above-mentioned, low-molecular organic light-emitting material, and a cathode 3 in that order on a light-transmitting substrate (transparent substrate) 1, and in which the laminate structure is sealed with a protective film 4.

The light-emitting layer 7 is formed by coating or printing a coating composition of ink that contains a low-molecular, organic light-emitting material to be mentioned hereinunder, or contains it along with a hole-transporting material and/or an electron-transporting material, on the substrate 1, and this is formed as a single coated or printed layer.

In this organic electroluminescent device A, the substrate 1 may be made of any suitable, light-transmitting material of, for example, glass, plastics, etc. Where the device A is combined with any other display devices, or where the structures of Fig. 1 are arranged in matrices, they may share the substrate illustrated in Fig. 1.

The anode 2 is a transparent electrode, and may be made of ITO (indium tin oxide), SnO₂ or the like. Where the protective film 4 is made of a conductive material such as metal or the like, an insulating film may be provided at the side surface of the anode 2.

If desired, a thin film of an organic substance or an organic metal compound may be sandwiched between the transparent electrode 2 and the light-emitting layer 7 for the purpose of improving the charge injection efficiency. In particular, where the substrate is made of a flexible material of, for example, plastics or the like, roll-to-roll continuous production is applicable to the device.

At least one or more materials are in the electroluminescent layer 7. For example, the material capable of forming the layer by itself without being combined with any others includes compounds that are so designed as to have the structure acting for electron transportation and for light emission and the structure containing an amino group or a substituted amino group in the molecule. The material having the properties of hole transportability, electron transportability and light emittability may form the electroluminescent layer by itself without being combined with any others. For the materials that could not exhibit satisfactory capabilities when used singly, at least one or more selected from hole-transporting material, electron-transporting materials, light-emitting materials and others shall be in the layer.

As the hole-transporting material, usable are any known ones including, for example, aromatic amines, pyrazolines, etc. The electron-transporting material includes metal complex compounds with aluminium or zinc, aromatic carbon compounds, and oxadiazoles. For the purpose of enhancing the light-emitting efficiency of the electroluminescent layer, a thin film for controlling the hole or electron transportation in the layer may be provided adjacent to the layer.

Coating the layer may be effected in air. However, where oxygen, water and others in air will remain in the thin film formed to have some negative influences on the driving life of the device, it is often effective to carry out the coating in a chemically inert vapor atmosphere of nitrogen, argon, neon, xenon, krypton or the like.

Spin coating as referred to herein for forming the layer indicates a coating method comprising applying a solution onto a substrate followed by spinning the thus-coated substrate to remove the excess solution, thereby forming a coating film having a predetermined thickness on the substrate. For the coating step, employable is any ordinary spin-coating apparatus.

Dipping indicates a method comprising dipping a substrate in a solution followed by taking the substrate out of the solution at a predetermined rate to thereby coat the substrate with the solution. For this, any ordinary dipping mode is employable.

For spray coating, various systems are employable. For example, one ordinary method is employable herein, in which a coating solution as put in a closed container is sprayed under pressure through fine nozzles of the container over a substrate to be coated therewith. Apart from this, also employable is an ink-jetting system.

For relief printing, lithographic printing, gravure printing, flexographic printing, screen printing and the like, the driving condition for the printer to be used must be suitably controlled in accordance with the viscosity of the coating solution. Of those, preferred is gravure printing, for which the viscosity of the printing ink may low and a volatile organic solvent may be used. However, without being limited to this, any other printing methods are employable herein.

In order to control the viscosity of the printing ink to be used, a side component of polyarylenes, polythiophenes and the like may be incorporated into the printing ink. To prepare the printing ink, usable is any suitable organic solvent selected from chloroform, dichloromethane, alcohols, cellosolves, ketones, aromatic hydrocarbons, etc.

The cathode 3 may have a synthetic or laminate structure of an electrode material comprising an active metal of Li, Mg, Ca or the like, and a metal of Ag, Al, In or the like. In general, the cathode is formed through vacuum vapor deposition. Preferably, however, an organic material containing a metal powder of Mg, Ag or the like is formed into the cathode through screen printing or coating, which is easy as in the formation of the light-emitting layer.

Controlling the thickness of the cathode makes the device have a desired light transmittance that is suitable to its use. In that manner, light-transmitting, electroluminescent devices can be produced. In those, a transparent electrode may be formed on the metal cathode in order to ensure stable electric connection.

Sealing with the protective film 4 or any other sealing container may be applied to the organic electroluminescent device for the purpose of shielding the device from oxygen and water to thereby ensure the driving reliability of the device. The material for the sealing container may be any one having vapor sealability, and includes glass, metals, ceramics, etc. The shape of the sealing container may also be any one capable of ensuring the vapor sealability of the container. For attaching the container to the substrate, any vapor-sealable resin is employable. The sealant resin may contain a thickener and a filler.

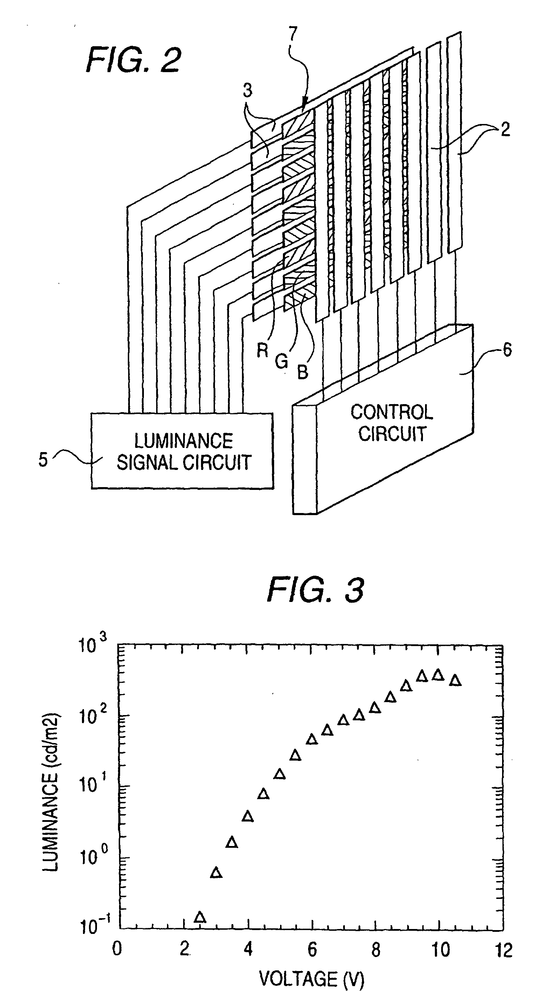

Next, Fig. 2 shows one constructional example of a flat display comprising the organic electroluminescent device of the invention. As illustrated, for example, in a full-color display, an organic layer 7 capable of emitting light of three primary colors, red (R), green (G) and blue (B), is sandwiched between a cathode 3 and an anode 2. The cathode 3 and the anode 2 may be stripe-wise disposed so that they cross each other, to which is separately imparted a signal voltage that is selected via a luminance signal circuit 5 and via a control circuit 6 with a built-in shift register. In that constitution, the organic layer emits light at the position (pixel) at which the selected cathode 3 and anode 2 cross each other. To form the pattern of the organic layer 7 in this case, for example, the area not intended to be patterned is masked with a photoresist or the like, then a coating solution for the organic layer is applied through spin coating, and the mask is peeled to form the intended organic layer. This patterning step may be repeated.

Now, the invention is described concretely with reference to the following Examples, which, however, are not intended to restrict the scope of the invention.

### Example 1

A chloroform solution of 1.5 % by weight of BSB-BCN having the constitutional formula mentioned below was put onto a glass substrate having a square size of 3 cm x 3 cm, on which had been formed an ITO pattern of 2 mm x 2 mm, and the substrate was then spun at 1500 rpm for 30 seconds to remove the excess solution and to dry the substrate. Next, this was heated in a vacuum drier at 80°C for 1 hour. The vacuum drying step may be omitted. As measured with a profilometer, the coating thickness was about 120 nm. Next, a cathode of AlLi having a thickness of 150 nm was formed on the organic layer, in a vacuum vapor deposition chamber under a vacuum degree of about 10⁻⁶ Torr (1.33·10⁻⁴ Pa).

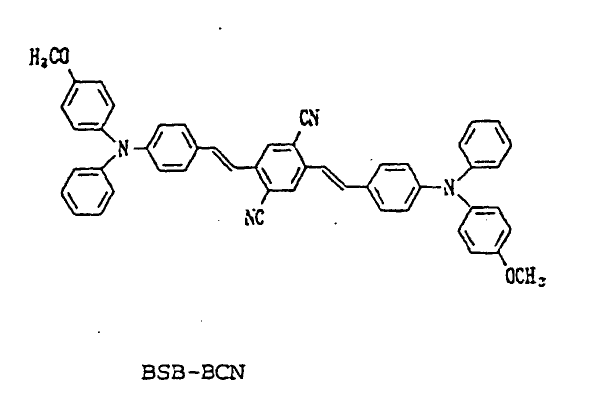

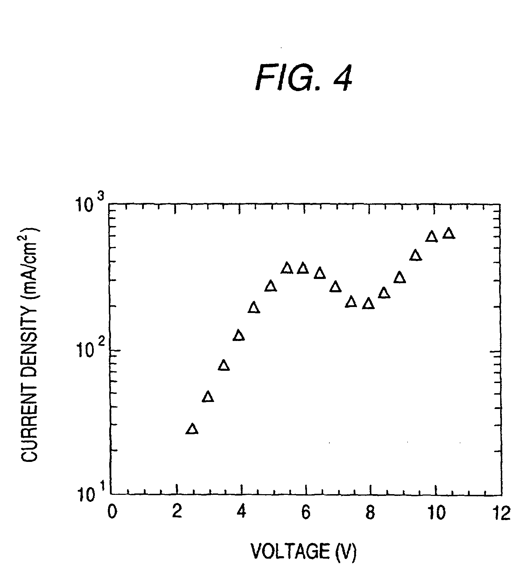

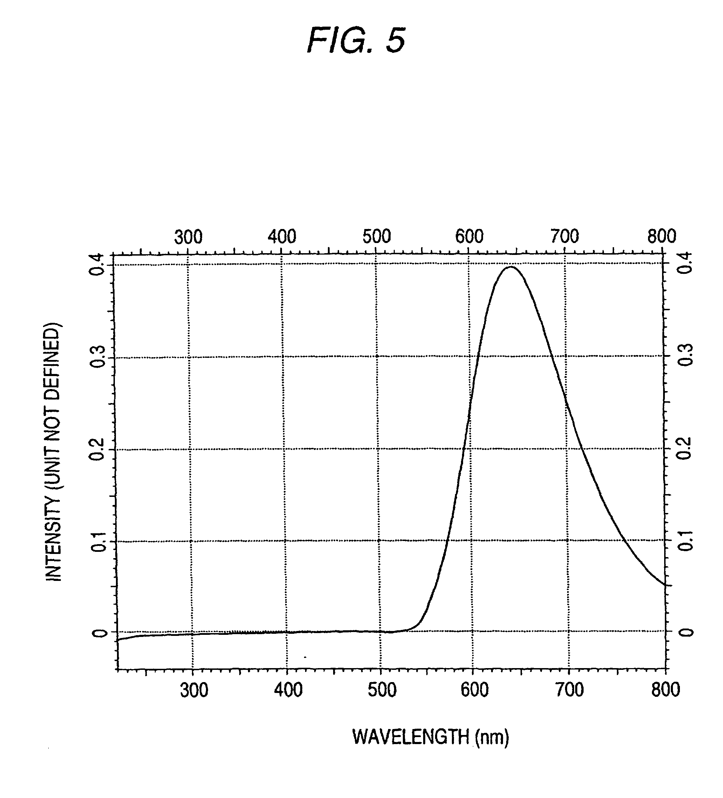

Fig. 3 shows the luminance-voltage characteristic of the device produced herein; and Fig. 4 shows the current density-voltage characteristic thereof. At a voltage of 2.5 V, the device started to emit light, and its luminance reached the maximum at about 11 V. The luminance was 400 cd/m². The current density-voltage characteristic of the device gave a unique profile, in which the current density first increased with the increase in the voltage, but then decreased once to the minimum at around 7.5 V, and again increased. At least at present, the reason for the profile is not clarified. The emission spectrum of the device is in Fig. 5, in which the wavelength for the maximum emission is around 650 nm.

The organic layer formed herein was compared with a layer as formed through vacuum vapor deposition. It was found that the luminance of the device formed herein was satisfactory for its visibility though the maximum luminance thereof was somewhat low.

### Example 2

Using the same glass substrate as in Example 1, formed was an organic electroluminescent device in the same manner as in Example 1. The coating solution used herein was prepared by dissolving a mixture (1/1 by weight) of BSB-BCN and a hole-transporting material of α-NPD having the structure mentioned below, in chloroform to have a concentration of 2 %. The substrate coated with the solution was spun at 1500 rpm for 30 seconds to remove the excess solution and to dry the substrate. Next, this was heated in a vacuum drier at 80°C for 1 hour. The vacuum drying step may be omitted. As measured with a profilometer, the coating thickness was about 120 nm. A cathode of AlLi having a thickness of 150 nm was formed on the organic layer, in a vacuum vapor deposition chamber under a vacuum degree of about 10⁻⁶ Torr (1.33·10⁻⁴ pa).

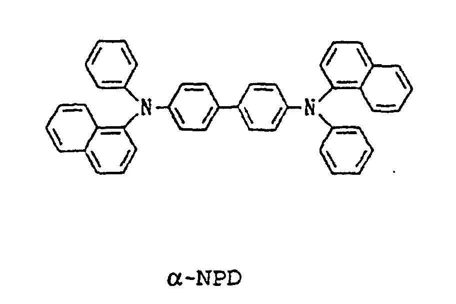

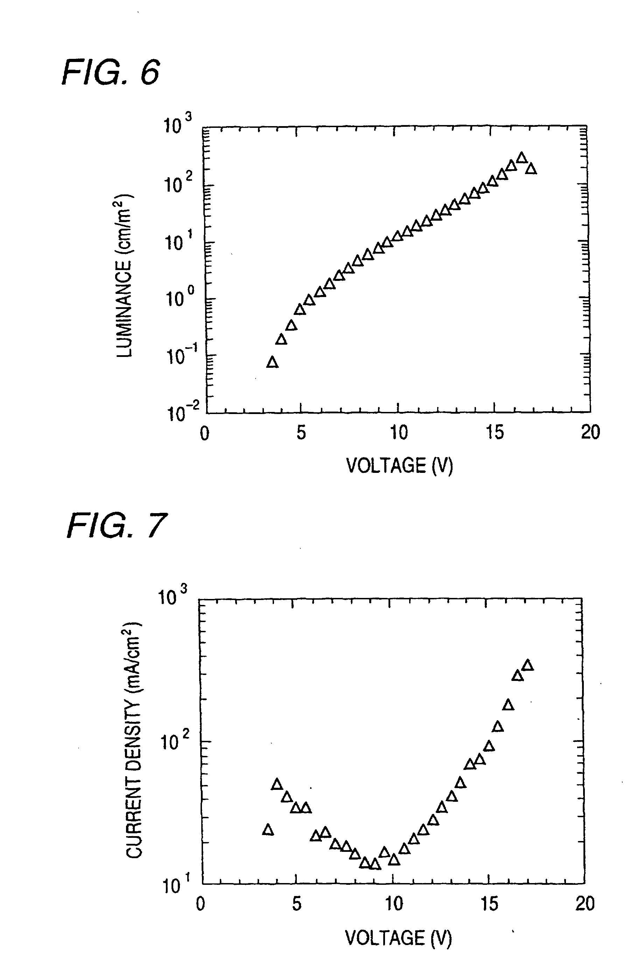

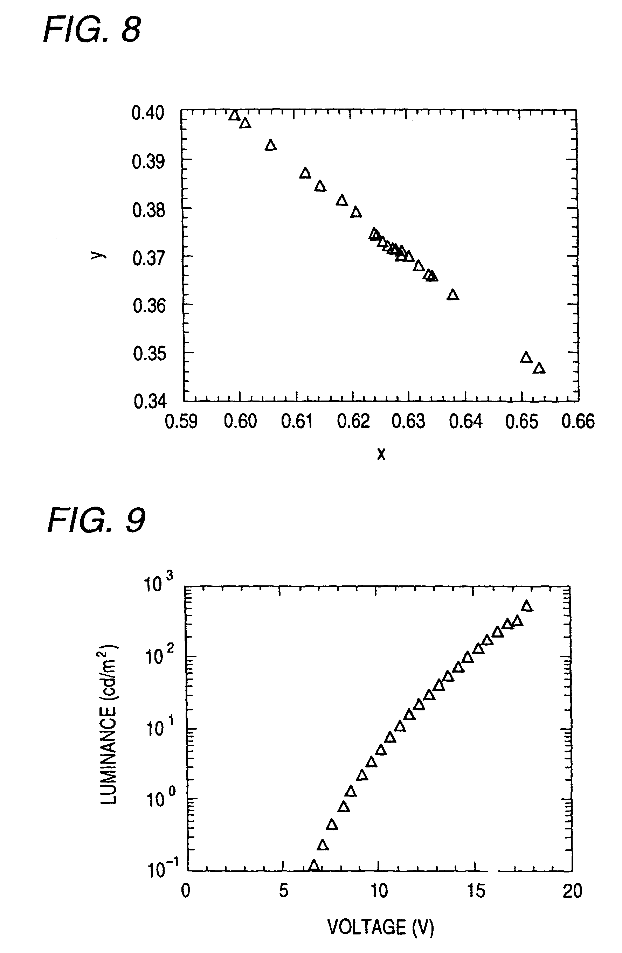

Fig. 6 shows the luminance-voltage characteristic of the device produced herein; and Fig. 7 shows the current density-voltage characteristic thereof. At a voltage of 3 V, the device started to emit light, and its luminance reached the maximum at about 16 V. The luminance was 300 cd/m². In the current density-voltage characteristic of the device, the current density decreased in the initial stage due to current leak, but thereafter increased with the increase in the voltage. The CIE chromaticity diagram of the luminescent color of the device is in Fig. 8. The luminescent color of the device shifted into the short wavelength side with the increase in the luminance. The device is applicable to color-changing electroluminescent appliances by voltage control.

### Example 3

Using the same glass substrate as in Example 1, formed was an organic electroluminescent device in the same manner as in Example 1. The coating solution used herein was prepared by dissolving a mixture (1/1/1 by weight) of BSB-BCN, a hole-transporting material of α-NPD and an electron-transporting material of Alq₃ having the constitutional formula mentioned below, in chloroform to have a concentration of 2 %. The substrate coated with the solution was spun at 1500 rpm for 30 seconds to remove the excess solution and to dry the substrate. Next, this was heated in a vacuum drier at 80°C for 1 hour. The vacuum drying step may be omitted. As measured with a profilometer, the coating thickness was about 120 nm. A cathode of AlLi having a thickness of 150 nm was formed on the organic layer, in a vacuum vapor deposition chamber under a vacuum degree of about 10⁻⁶ Torr (1.33·10⁻⁴ Pa).

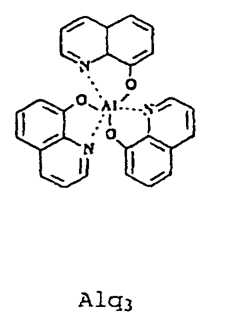

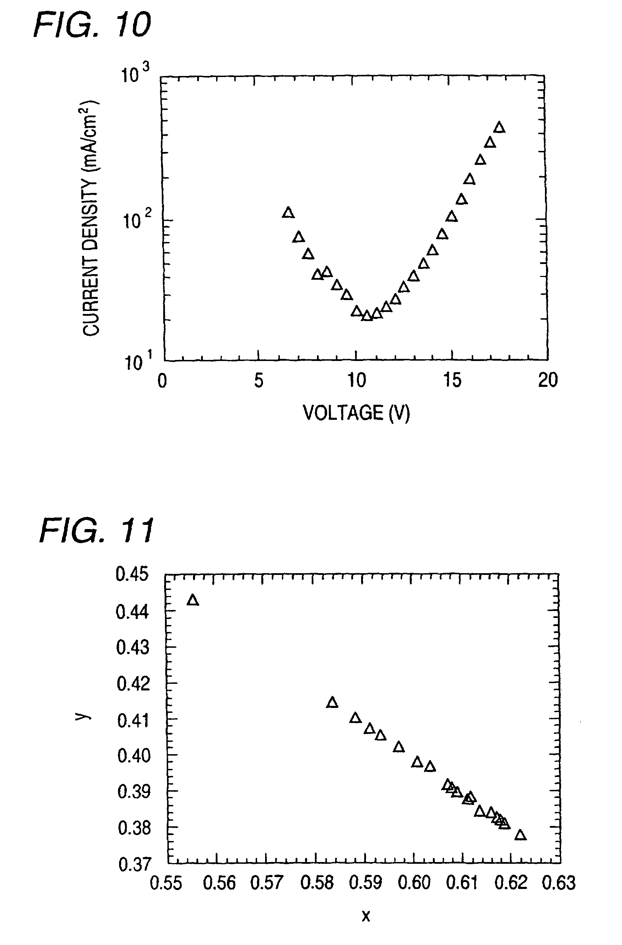

Fig. 9 shows the luminance-voltage characteristic of the device produced herein; and Fig. 10 shows the current density-voltage characteristic thereof. At a voltage of 6.5 V, the device started to emit light, and its luminance reached the maximum at about 17 V. The luminance was 300 cd/m². In the current density-voltage characteristic of the device, the current density decreased in the initial stage due to current leak, and the minimum current density appeared at around 10 V. The CIE chromaticity diagram of the luminescent color of the device is in Fig. 11. The luminescent color of the device shifted into the short wavelength side with the increase in the luminance. The device is applicable to color-changing electroluminescent appliances by voltage control. The luminance of the device increased with the increase in the voltage, from which it is believed that the minimum current density appearing in the current density-voltage characteristic of the device will be caused by the change of the light-emitting substance for another.

From the above and as in Examples 1 to 3, it was verified that low-molecular materials and even their mixtures in one layer could bring about electroluminescence.

### Example 4

The same solution as in Example 1 was adhered to a silicone rubber, and transferred onto a polyethylene terephthalate substrate having a thickness of 500 µm and having an ITO layer formed thereon, through flexographic printing. Then, the solvent was removed under heat, and the substrate was heated in a vacuum drier at 80°C for 1 hour. As measured with a profilometer, the coating thickness was about 100 nm. A cathode of AlLi having a thickness of 150 nm was formed on the organic layer, in a vacuum vapor deposition chamber under a vacuum degree of about 10⁻⁶ Torr (1.33·10⁻⁴ Pa). The light emission was confirmed upon applying a voltage, as in Example 2. The maximum luminance of the device was 200 cd/m² at 15 V.

### Example 5

Using the same glass substrate as in Example 1, formed was an organic electroluminescent device in the same manner as in Example 1. The coating solution used herein was prepared by dissolving a mixture (1/1/1 by weight) of a blue-emitting material of DPVBi having the constitutional formula mentioned below, a hole-transporting material of m-MTDATA having the constitutional formula mentioned below, and an electron-transporting material of Alq₃ having the constitutional formula mentioned below, in chloroform to have a concentration of 2 %. The substrate coated with the solution was spun at 1500 rpm for 30 seconds to remove the excess solution and to dry the substrate. Next, this was heated in a vacuum drier at 80°C for 1 hour. The vacuum drying step may be omitted. A cathode of AlLi having a thickness of 150 nm was formed on the organic layer, in a vacuum vapor deposition chamber under a vacuum degree of about 10⁻⁶ Torr (1.33·10⁻⁴ Pa).

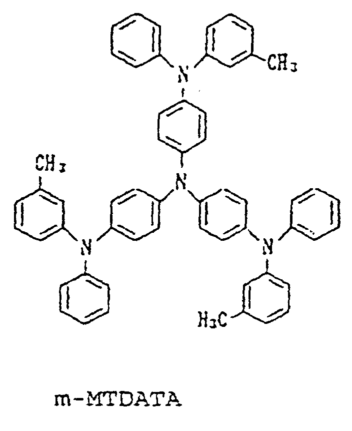

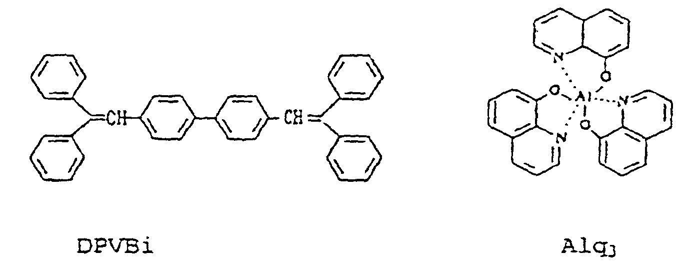

The light emission was confirmed upon applying a voltage. Its luminescent color was first green, and then shifted into the short wavelength side with the increase in the voltage. The maximum luminance of the device was 200 cd/m² at 15 V.

### Example 6

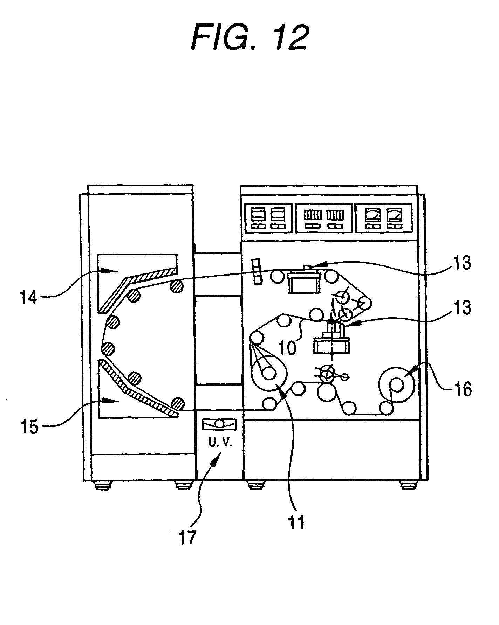

Using a micro-gravure coater shown in Fig. 12, a coating test was carried out. A solution to be tested was prepared by dissolving a mixture (1/1/1 by weight) of BSB-BCN, a hole-transporting material of α-NPD, and an electron-transporting material of Alq₃, in a mixed solvent (28/8/3 by weight) of chloroform, tetrachloroethane and cyclohexanone to have a concentration of 2 %. Using the mixed solvent herein is in order to prevent chloroform from evaporating during the test, as the boiling point of chloroform is low.

As the micro-gravure coater, used was Micro-Gravure Test Coater of Yasui Seiki KK. As the gravure roll, used was Aniax Roll of Yasui Seiki KK, which was of an oblique line type of 110 lines/inch and had a diameter of 20 mm. The number of gravure roll revolutions was 5 graduations in terms of the graduations on the coater; the coating linear rate was 3 m/s, and the drying was with a hot air stream at 70°C. As the substrate, used was a polyethylene terephthalate film (having a width of 5 inches and a thickness of 100 µm) on which had been formed an ITO electrode pattern. The ITO electrode pattern had a width of 1 mm l/s, and a length of 10 cm.

The film formed on the base film was heated in a vacuum drier at 80°C for 1 hour. As measured with a profilometer, the thickness of the film formed was about 100 nm. A cathode of AlLi having a thickness of 150 nm was formed on the organic layer, in a vacuum vapor deposition chamber under a vacuum degree of about 10⁻⁶ Torr (1.33·10⁻⁴ Pa). The light emission was confirmed upon applying a voltage, as in Example 3. The maximum luminance of the device was 180 cd/m² at 15 V.

In the organic EL device and the production method of the invention, an organic light-emitting material not having any polymeric repetition in the chemical structure (that is, a low-molecular one) is coated or printed. Therefore, the invention where a solution of such a low-molecular, organic light-emitting material is coated or printed to produce the device is superior to using high-molecular materials in that the wavelength of the light to be emitted by the device and also the thermal characteristics and others of the device are easily controlled through molecular designing of the low-molecular material to be used, that the synthetic reaction for producing the low-molecular material is controlled with accuracy as not including polymerization, and that the synthesized low-molecular material can be purified more easily than high-molecular materials. According to the invention, therefore, there are provided high-performance devices at low costs, and the producibility for the devices is high.

In addition, the organic light-emitting material forms a single coated or printed layer as a light-emitting layer in the device of the invention. Therefore, the invention does not require the formation of conventional laminate structures, and the operation for forming the layer is easy. The layer can be formed in a simplified manner merely by settling the coating or printing condition for it.

While the invention has been described in detail and with reference to specific embodiments thereof, it will be apparent to one skilled in the art that various changes and modifications can be made therein without departing from the scope thereof.

## Claims

1. An organic electroluminescent device comprising an anode and a cathode and a single coated or printed layer between the anode and the cathode, wherein the coated or printed layer comprises at least one organic light-emitting material which does not have any polymeric repetition in the chemical structure.

2. The organic electroluminescent device as claimed in claim 1, wherein said organic light-emitting material is in a light-emitting layer.

3. The organic electroluminescent device as claimed in claim 2, wherein said light-emitting layer contains at least one of a hole-transporting material and an electron-transporting material.

4. The organic electroluminescent device as claimed in claim 2, wherein the driving electrode for said light-emitting layer is formed through coating or printing of an organic material containing a conductive powder.

5. A method for producing an organic electroluminescent device according to claim 1, which comprises a step of coating or printing a material that contains at least one organic light-emitting material not having any polymeric repetition in the organic structure, thereby forming a coated or printed layer of said organic light-emitting material.

6. The method for producing an organic electroluminescent device as claimed in claim 5, wherein said coating is effected by spin coating.

7. The method for producing an organic electroluminescent device as claimed in claim 5, wherein said coating is effected by dipping.

8. The method for producing an organic electroluminescent device as claimed in claim 5, wherein said coating is effected by spray coating.

9. The method for producing an organic electroluminescent device as claimed in claim 5, wherein said printing is effected by any of relief printing, lithographic printing, gravure printing, flexographic printing or screen printing.

10. The method for producing an organic electroluminescent device as claimed in claim 5, wherein said organic light emitting material is in a light-emitting layer as formed through coating or printing.

11. The method for producing an organic electroluminescent device as claimed in claim 10, wherein said light-emitting layer contains at least one of a hole-transporting material and an electron-transporting material, and said organic light-emitting material is formed through coating.

12. The method for producing an organic electroluminescent device as claimed in claim 10, wherein said light-emitting layer contains at least one of a hole-transporting material and an electron-transporting material, and said organic light-emitting material is formed through printing.

13. The method for producing an organic electroluminescent device as claimed in claim 10, wherein the driving electrode for said light-emitting layer is formed through coating of an organic material containing a conductive powder.

## Patentansprüche

1. Organisches Elektrolumineszenzelement mit einer Anode und einer Kathode sowie einer einzelnen aufgetragenen oder aufgedruckten Schicht zwischen der Anode und der Kathode, wobei die aufgetragene oder aufgedruckte Schicht mindestens ein organisches, Licht emittierendes Material enthält, das über keinerlei Polymerwiederholung in der chemischen Struktur verfügt.

2. Organisches Elektrolumineszenzelement nach Anspruch 1, bei dem das organische, Licht emittierende Material in einer Licht emittierenden Schicht vorhanden ist.

3. Organisches Elektrolumineszenzelement nach Anspruch 2, bei dem die Licht emittierende Schicht ein Löcher transportierendes Material und/oder ein Elektronen transportierendes Material enthält.

4. Organisches Elektrolumineszenzelement nach Anspruch 2, bei dem die Ansteuerelektrode für die Licht emittierende Schicht durch Auftragen oder Aufdrucken eines organischen Materials, das ein leitendes Pulver enthält, hergestellt ist.

5. Verfahren zum Herstellen eines organischen Elektrolumineszenzelements nach Anspruch 1, mit einem Schritt zum Auftragen oder Aufdrucken eines Materials, das mindestens ein organisches, Licht emittierendes Material ohne irgendeine Polymerwiederholung in der organischen Struktur enthält, um dadurch eine aufgetragene oder aufgedruckte Schicht des organischen, Licht emittierenden Materials herzustellen.

6. Verfahren zum Herstellen eines organischen Elektrolumineszenzelements nach Anspruch 5, bei dem das Auftragen durch Schleuderbeschichten erfolgt.

7. Verfahren zum Herstellen eines organischen Elektrolumineszenzelements nach Anspruch 5, bei dem das Auftragen durch Eintauchen erfolgt.

8. Verfahren zum Herstellen eines organischen Elektrolumineszenzelements nach Anspruch 5, bei dem das Beschichten durch Sprühbeschichten erfolgt.

9. Verfahren zum Herstellen eines organischen Elektrolumineszenzelements nach Anspruch 5, bei dem das Aufdrucken durch Hochdruck, lithografischen Druck, Tiefdruck, Tampondruck oder Siebdruck erfolgt.

10. Verfahren zum Herstellen eines organischen Elektrolumineszenzelements nach Anspruch 5, bei dem das organische, Licht emittierende Material in einer Licht emittierenden Schicht vorhanden ist, die durch Auftragen oder Aufdrucken hergestellt wird.

11. Verfahren zum Herstellen eines organischen Elektrolumineszenzelements nach Anspruch 10, bei dem die Licht emittierende Schicht ein Löcher transportierendes Material und/oder ein Elektronen transportierendes Material enthält und das organische, Licht emittierende Material durch Auftragen hergestellt wird.

12. Verfahren zum Herstellen eines organischen Elektrolumineszenzelements nach Anspruch 10, bei dem die Licht emittierende Schicht ein Löcher transportierendes Material und/oder ein Elektronen transportierendes Material enthält und das organische, Licht emittierende Material durch Aufdrucken hergestellt wird.

13. Verfahren zum Herstellen eines organischen Elektrolumineszenzelements nach Anspruch 10, bei dem die Ansteuerelektrode für die Licht emittierende Schicht durch Auftragen eines organischen Materials, das ein leitendes Pulver enthält, hergestellt wird.

## Revendications

1. Dispositif électro-luminescent organique comprenant une anode et une cathode et une couche unique enduite ou imprimée entre l'anode et la cathode, dans lequel la couche enduite ou imprimée comprend au moins un matériau luminescent organique qui n'a aucune répétition polymère dans sa structure chimique.

2. Dispositif électro-luminescent organique selon la revendication 1, dans lequel ledit matériau luminescent organique est dans une couche luminescente.

3. Dispositif électro-luminescent organique selon la revendication 2, dans lequel ladite couche luminescente contient au moins l'un d'un matériau de transport de trous et d'un matériau de transport d'électrons.

4. Dispositif électro-luminescent organique selon la revendication 2, dans lequel l'électrode de commande pour ladite couche luminescente est formée en enduisant ou en imprimant un matériau organique contenant une poudre conductrice.

5. Procédé pour fabriquer un dispositif électro-luminescent organique selon la revendication 1, qui comprend une opération consistant à enduire ou imprimer un matériau qui contient au moins un matériau luminescent organique n'ayant aucune répétition polymère dans sa structure organique, formant ainsi une couche enduite ou imprimée dudit matériau luminescent organique.

6. Procédé pour fabriquer un dispositif électro-luminescent organique selon la revendication 5, dans lequel ladite couche est réalisée par revêtement par centrifugation.

7. Procédé pour fabriquer un dispositif électro-luminescent organique selon la revendication 5, dans lequel ladite couche est réalisée par immersion.

8. Procédé pour fabriquer un dispositif électro-luminescent organique selon la revendication 5, dans lequel ladite couche est réalisée par revêtement par pulvérisation.

9. Procédé pour fabriquer un dispositif électro-luminescent organique selon la revendication 5, dans lequel ladite impression est effectuée par l'une quelconque de l'impression en relief, de l'impression offset, de l'héliogravure, de la flexographie ou de la sérigraphie.

10. Procédé pour fabriquer un dispositif électro-luminescent organique selon la revendication 5, dans lequel ledit matériau organique luminescent est dans une couche luminescente formée par enduction ou par impression.

11. Procédé pour fabriquer un dispositif électro-luminescent organique selon la revendication 10, dans lequel ladite couche luminescente contient au moins l'un d'un matériau de transport de trous et d'un matériau, de transport d'électrons et ledit matériau luminescent organique est formé par enduction.

12. Procédé pour fabriquer un dispositif électro-luminescent organique selon la revendication 10, dans lequel ladite couche luminescente contient au moins un d'un matériau de transport de trous et d'un matériau de transport d'électrons et ledit matériau luminescent organique est formée par impression.

13. Procédé pour fabriquer un dispositif électro-luminescent organique selon la revendication 10, dans lequel l'électrode de commande pour ladite couche luminescente est formée par enduction d'un matériau organique contenant une poudre conductrice.
